(19) **Europäisches Patentamt / European Patent Office / Office européen des brevets**

(11) **EP 1 688 514 B1**

(12) **EUROPEAN PATENT SPECIFICATION**

(45) Date of publication and mention
of the grant of the patent:
**25.08.2010 Bulletin 2010/34**

(21) Application number: **04818907.0**

(22) Date of filing: **16.11.2004**

(51) Int Cl.:
*C23C 14/24* (2006.01)    *H05B 3/14* (2006.01)

(86) International application number:
**PCT/JP2004/017023**

(87) International publication number:
**WO 2005/049881 (02.06.2005 Gazette 2005/22)**

(54) **METAL VAPORIZING HEATING ELEMENT AND METAL VAPORIZING METHOD**

METALLVERDAMPFUNGSHEIZELEMENT UND METALLVERDAMPFUNGSVERFAHREN

ELEMENT CHAUFFANT A VAPORISATION DE METAUX ET PROCEDE CORRESPONDANT

(84) Designated Contracting States:
**DE FR GB**

(30) Priority: **20.11.2003   JP 2003390344**
**15.01.2004   JP 2004008217**
**16.07.2004   PCT/JP2004/010568**

(43) Date of publication of application:
**09.08.2006   Bulletin 2006/32**

(73) Proprietor: **DENKI KAGAKU KOGYO KABUSHIKI KAISHA**
**Tokyo 103-8338 (JP)**

(72) Inventors:
• **IKARASHI, Kouki,**
**c/o Denki Kagaku Kogyo K.K.**
**Omuta-shi,**
**Fukuoka 8368510 (JP)**
• **MIYAI, Akira,**
**c/o Denki Kagaku Kogyo K.K.**
**Omuta-shi,**
**Fukukoka 8368510 (JP)**

• **WATANABE, Shoujiro,**
**c/o Denki Kagaku Kogyo K.K.**
**Omuta-shi,**
**Fukuoka 8368510 (JP)**
• **SUSAKI, Junichi,**
**c/o Denki Kagaku Kogyo K.K.**
**Omuta-shi,**
**Fukuoka 8368510 (JP)**
• **IWAMOTO, Kentaro,**
**c/o Denki Kagaku Kogyo K.K.**
**Omuta-shi,**
**Fukuoka 8368510 (JP)**

(74) Representative: **Hartz, Nikolai**
**Wächtershäuser & Hartz**
**Patentanwaltspartnerschaft**
**Weinstrasse 8**
**80333 München (DE)**

(56) References cited:
**EP-A1- 0 960 956      JP-A- 6 298 566**
**JP-A- 50 161 505      JP-A- 60 086 270**
**JP-A- 2002 097 565    JP-U- 47 002 762**
**US-A- 2 962 538       US-A- 3 803 707**

**Description**

TECHNICAL FIELD

The present invention relates to a metal evaporation heating element and a method for evaporating a metal.

BACKGROUND ART

Heretofore, as a metal evaporation heating element (hereinafter sometimes referred to as "boat"), for example, an electrically conductive ceramic sintered body comprising boron nitride (BN), aluminum nitride (AlN) and titanium diboride ($TiB_2$) as the main components and having a cavity formed on the upper surface thereof has been known (JP-B-53-20256). As one example of commercial products, "BN COMPOSITE EC", tradename, manufactured by Denki Kagaku Kogyo Kabushiki Kaisha may be mentioned.

As a method of using the boat, each end of the boat is connected to an electrode by a clamp, a voltage is applied to generate heat, and a metal such as an Al wire rod put in the cavity is melted and evaporated to obtain a deposited film, followed by cooling. Such an operation is repeatedly carried out, during which the boat undergoes temperature cycles and erosion by the molten metal, and it will reach the end of its usefulness.

The boat life greatly relates to wettability of the boat to the molten metal, and if the wettability is poor, not only the molten metal is localized and no evaporation efficiency inherent in the boat will be obtained, but also the progress of erosion of the boat by the molten metal will be accelerated, whereby the boat life will be shortened. Accordingly, in order to secure the wettability of the boat, various attempts have been made such as irradiation with laser (JP-A-2000-93788), but no sufficient prolongation of life has been achieved. Further, extensive apparatus and facility will be required for irradiation with laser.

US 2962538 discloses a vaporizing element for the deposition of metals composed of a refractory material such as the carbides, borides, nitrides and silicides of the transition metals belonging to groups IV, V and VI of the periodic system of the elements, and having a body with top area having a plurality of grooves with widths of 0.254 to 1.270 mm and depths of 0.127 to 1.524 mm.

DISCLOSURE OF THE INVENTION

OBJECT TO BE ACCOMPLISHED BY THE INVENTION

It is an object of the present invention to provide a metal evaporation heating element (boat) which has improved wettability to a molten metal and which has a prolonged life, and a method for evaporating a metal using it.

(1) A metal evaporation heating element having one or more grooves in a direction not in parallel with a current direction, on an upper surface of a sintered body wherein the groove has a width of from 0.1 to 1.5 mm, a depth of from 0.03 to 1 mm and a length of at least 1 mm, as further defined in claim 1.

(2) The metal evaporation heating element according to the above (1), characterized by having at least two grooves with a distance of at most 2 mm.

(3) The metal evaporation heating element according to the above (1) or (2), characterized in that the number of grooves is at least 10.

(4) The metal evaporation heating element according to the above (1), characterized in that the grooves are crossed so as to form at least one intersection.

(5) The metal evaporation heating element according to any one of the above (1) to (4), characterized in that the ceramic sintered body has a cavity, and the groove is formed on the bottom surface of the cavity and/or on the upper surface of the ceramic sintered body.

(6) The metal evaporation heating element according to any one of the above (1) to (5), characterized in that a pattern is drawn by a plurality of grooves on the bottom surface of the cavity and/or on the upper surface of the ceramic sintered body.

(7) The metal evaporation heating element according to the above (6), characterized in that the area ratio occupied by the pattern is at least 30% to the bottom surface area of the cavity with respect to one having a cavity, or to the upper surface area of the ceramic sintered body with respect to one having no cavity.

(8) The metal evaporation heating element according to the above (7), characterized in that the area ratio occupied by the pattern is at least 50%.

(9) The metal evaporation heating element according to the above (7), characterized in that the area ratio occupied by the pattern is at least 80%.

(10) The metal evaporation heating element according to any one of the above (1) to (9), characterized in that in one groove, or between different grooves, a significant difference is provided in the depth of the groove.

(11) The metal evaporation heating element according to the above (10), characterized in that the significant difference in the depth of the groove is at least 10%.

(12) The metal evaporation heating element according to the above 10 or (11), characterized in that among a plurality of grooves, the groove having the deepest portion is provided at a center portion in the longitudinal direction of the ceramic sintered body or in the vicinity thereof.

(13) The metal evaporation heating element according to any one of the above (10) to (12), characterized in that among the plurality of grooves, the groove having the shallowest portion is provided at one end or each end in the longitudinal direction of the ceramic sintered body.

(14) The metal evaporation heating element according to any one of the above (10) to (13), characterized in that {(depth of the deepest portion of the groove) - (depth of the shallowest portion of the groove)} is at least 0.005 mm.

(15) A method for evaporating a metal, characterized by using the metal evaporation heating element as defined in any one of the above (1) to (14) and heating a metal in vacuum in a state where the metal is in contact with part or all of the groove.

BRIEF DESCRIPTION OF THE DRAWINGS

Fig. 1 is a perspective view illustrating one reference example of the boat of the present invention.
Fig. 2 is a perspective view illustrating one example
Fig. 3 is a perspective view illustrating one example of the boat of the present invention.
Fig. 4 is a perspective view illustrating one example of the boat of the present invention.
Fig. 5 is a perspective view illustrating one example of the boat of the present invention.
Fig. 6 is a perspective view illustrating one reference example.
Fig. 7 is a perspective view illustrating one example of the boat of the present invention.
Fig. 8 is a perspective view illustrating one example of the boat of the present invention.
Fig. 9 is a perspective view illustrating one example of the boat of the present invention.
Fig. 10 is a perspective view illustrating one example of the boat of the present invention.

BEST MODE FOR CARRYING OUT THE INVENTION

As the composition of the ceramic sintered body to be used in the present invention, it contains at least an electrically conductive substance titanium diboride and/or zirconium diboride and an insulating substance boron nitride as essential components. An electrically conductive substance such as titanium nitride, silicon carbide or chromium carbide and an insulating substance such as aluminum nitride, silicon nitride, alumina, silica or titanium oxide may suitably be incorporated. Among them, preferred is one containing as the main components titanium diboride and/or zirconium diboride, and boron nitride, or one containing as the main components titanium diboride and/or zirconium diboride, and boron nitride and aluminum nitride. Particularly preferred is one containing from 30 to 60% (hereinafter % means mass% unless otherwise specified) of titanium diboride and/or zirconium diboride and from 70 to 40% of boron nitride, or one containing from 35 to 55% of titanium diboride and/or zirconium diboride, from 25 to 40% of boron nitride and from 5 to 40% of aluminum nitride. When the ceramic sintered body has such a composition, it will very easily be processed.

Further, the ceramic sintered body has a relative density of preferably at least 90%, particularly preferably at least 93%. If the relative density is less than 90%, the molten metal will erode the pores of the ceramic sintered body, whereby erosion will be accelerated. A relative density of at least 90% will be easily realized by incorporating a sintering aid as described hereinafter to the above composition within a range not exceeding 10%. The relative density of the ceramic sintered body is determined by processing the sintered body into a rectangular solid having predetermined dimensions and dividing the actually measured density obtained from the outer dimensions and the mass by the theoretical density.

The ceramic sintered body to be used in the present invention can be produced by forming a material powder mixture containing an electrically conductive substance titanium diboride and/or zirconium diboride and an insulating substance boron nitride and sintering the mixture.

A material titanium diboride powder may be produced by any production method such as a method of utilizing a direct reaction with metal titanium or a reduction of an oxide such as titania. The powder preferably has an average particle size of from 5 to 25 $\mu$m.

A boron nitride powder is preferably hexagonal boron nitride or amorphous boron nitride or a mixture thereof. The powder may be produced, for example, by a method of heating a mixture of borax with urea in an ammonia atmosphere at 800°C or higher, or a method of heating a mixture of boric acid or boron oxide with calcium phosphate and a nitrogen-containing compound such as ammonium or dicyandiamide at 1,300°C or higher. Further, the boron nitride powder may be heated at high temperature in a nitrogen atmosphere thereby to increase crystallinity. The boron nitride powder has an average particle size of preferably at most 10 $\mu$m, particularly preferably at most 5 $\mu$m.

An aluminum nitride powder may be produced by a direct nitriding method or an alumina reduction method, and it has an average particle size of preferably at most 10 $\mu$m, particularly preferably at most 7 $\mu$m.

As a sintering aid, one or more powders selected from the group consisting of an alkaline earth metal oxide, an oxide of a rare earth element and a compound to be converted to such an oxide by heating. Specifically, it may, for example, be CaO, MgO, SrO, BaO, $Y_2O_3$, $La_2O$) , $Ce_2O_3$, $Pr_2O_3$, $Nd_2O_3$, $Pm_2O_3$, $Sm_2O_3$, $Eu_2O_3$, $Gd_2O_3$, $Tb_2O_3$, $Dy_2O_3$, $Ho_2O_3$, $Er_2O_3$, $Tm_2O_3$, $Yb_2O_3$ or $Lu_2O_3$, or a compound to be converted to such an oxide by heating, such as a hydroxide such as $Ca(OH)_2$ or a carbonate such as $MgCO_3$. The sintering aid has an average particle size of preferably at most 5 $\mu$m, particularly preferably at most 1 $\mu$m.

The material powder mixture containing the above components is preferably granulated, and then formed and sintered. As one example of the forming and sintering conditions, uniaxial pressing or cold isostatic pressing under from 0.5 to 200 MPa is carried out, and then normal pressure sintering or low pressure sintering under 1 MPa or below is carried out at a temperature of from 1,800 to 2,200°C. As an example of more preferred conditions, hot pressing or hot isostatic pressure under from 1 to 100 MPa is carried out at from 1,800 to 2,200°C.

Sintering is carried out preferably in a state where the mixture is accommodated in a container made of graphite, a container made of boron nitride, a container lined with boron nitride, or the like. In the case of hot pressing, sintering is carried out preferably by using a sleeve made of graphite or boron nitride, a sleeve lined with boron nitride, or the like.

Production of a boat from the ceramic sintered product can be carried out, for example, by forming the sintered body into a suitable shape by means of e.g. mechanical processing. Further, in the boat of the present invention, a cavity may be formed on a substantially center portion on the upper surface of the ceramic sintered body. As one example of the boat shape, the boat has a plate shape having a whole dimension with a length of from 100 to 200 mm, a width of from 25 to 35 mm and a thickness of from 8 to 12 mm. In a case where a cavity is formed, the cavity may, for example, have a rectangular shape having a length of from 90 to 120 mm, a width of from 20 to 32 mm and a depth of from 0.5 to 2 mm.

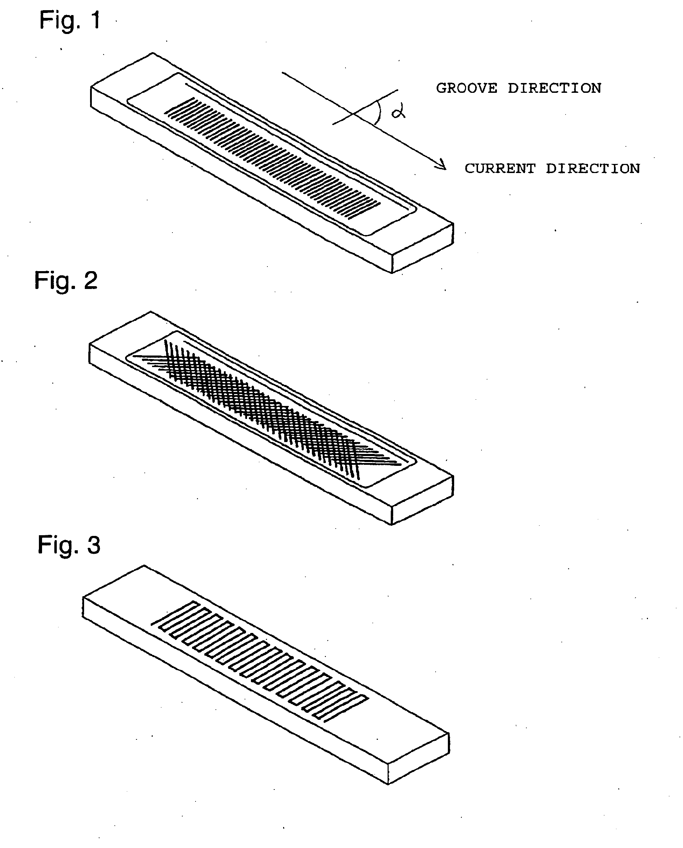

The boat of the present invention has, on the upper surface of the ceramic sintered body, or with respect to one having a cavity, on the bottom surface of the cavity and/or on the upper surface of the ceramic sintered body, one or more grooves in a direction not in parallel with a current direction (i.e. a direction connecting electrodes), i.e. with a predetermined angle $\alpha$ with the current direction which is the longitudinal direction of the ceramic sintered body as shown in Fig. 1. By such a groove, wetting in a direction in parallel with the current direction will be suppressed, wetting in a direction at right angles to current direction will be accelerated, and wettability will further improve.

An angle $\alpha$ in a direction not in parallel with the current direction is, as shown in Figs. 1, 3 to 5, and 7 to 10, from 60 to 120° to the current direction. The groove preferably has a linear shape with a rectangular cross section preferably having a width of from 0.1 to 1.5 mm, a depth of from 0.03 to 1 mm and a length of at least 1 mm, particularly preferably a width of from 0.3 to 1 mm, a depth of from 0.05 to 0.2 mm and a length of at least 10 mm. Although only one groove can improve wettability to a molten metal, the number of grooves is preferably at least 2, particularly preferably at least 10, furthermore preferably at least 30. In a case where there are two or more grooves, the distance between the grooves is preferably at most 2 mm, particularly preferably from 0.5 to 1.5 mm.

Particularly, it is preferred that the grooves are crossed so as to form at least one intersection, preferably intersections in the same or more number of the grooves, or on the upper portion of the ceramic sintered body and/or on the bottom of the cavity, a pattern (planar pattern) such as a circular, elliptic, rhomboidal, rectangular, mooned, lattice or radial pattern is drawn by the grooves. The area ratio occupied by the pattern is preferably at least 30%, particularly preferably at least 50%, more preferably at least 80% to the bottom surface area of the cavity with respect to one having a cavity, or to the upper surface area of the ceramic sintered body with respect to one having no cavity. The area ratio occupied by the pattern is defined as a percentage of a value obtained by dividing the area formed by connecting outermost grooves forming the pattern by the upper surface area of the ceramic sintered body or the bottom surface area of the cavity. When the area ratio occupied by the groove is employed instead of the area ratio occupied by the pattern, the area ratio occupied by the groove to the upper surface area of the ceramic sintered body or the bottom surface area of the cavity is preferably at least 10%, particularly preferably at least 30%, more preferably at least 50%.

Further, in the present invention, in one groove or between different grooves to be formed on the ceramic sintered body, a significant difference is preferably provided in the depth of the groove. By the significant difference, wettability to a molten metal will further be accelerated. In the present invention, the significant difference (%) in the depth of the groove is represented by the following formula. A groove to be used to measure the depth of the deepest portion of the groove and a groove to be used to measure the depth of the shallowest portion of a groove for the following formula may be the same or different.

$$\{(depth\ of\ the\ deepest\ portion\ of\ the\ groove) - (depth\ of\\ the\ shallowest\ portion\ of\ the\ groove)\} \times 100/(depth\ of\\ the\ deepest\ portion\ of\ the\ groove)$$

In the present invention, the significant difference of the groove by the above formula is preferably at least 10%, more preferably at least 20%, particularly preferably at least 30%. Further, regardless of the above formula or in relation to the above formula, the depth of the groove is suitably such that {(depth of the deepest portion of the groove) - (depth of the shallowest portion of the groove)} is preferably at least 0.005 mm, particularly preferably at least 0.1 mm.

In the present invention, the significant difference in the depth of the groove may be provided by (i) providing a significant difference in the depth of the groove in at least one groove among a plurality of grooves, (ii) providing a significant difference in the depth of the groove between two or more grooves, or (iii) a combination thereof.

In the case of the above method (i), the deepest portion in one groove is suitably provided preferably at a center portion with a length of from 10 to 80%, particular preferably at a center portion with a length of from 40 to 60% in the longitudinal direction of the groove, and the shallowest portion is suitably provided at the other end portion in the longitudinal direction.

In the case of the above method (ii), the groove employed to determine "the deepest portion of the groove" and the groove employed to determine "the shallowest portion of the groove" may be the same or different. Further, a plurality of grooves having different depths, each having a uniform depth, may be provided, or at least one groove among the plurality of grooves may be a groove having a non-uniform depth as in (i). Further, in the case of the above (iii), a groove having a uniform depth and a groove having a non-uniform depth are combined.

Further, in the case of the above (ii) or (iii), a deep groove (including a groove having the deepest portion) and a shallow groove (including a groove having the shallowest portion) are freely arranged, such that they are alternately provided, two or more grooves and two or more of the other types of grooves are alternately provided, or they are randomly provided. However, a deep groove (including a groove having the deepest portion) is preferably provided at a center portion in the longitudinal direction of the ceramic sintered body or in the vicinity thereof. The center portion in the longitudinal direction of the ceramic sintered body or in the vicinity thereof, is preferably a center region with a length of preferably from 20 to 80%, more preferably from 30 to 70%, particularly preferably from 40 to 60%, of the total length of the ceramic sintered body. Further, it is preferred to provide a groove shallower than the deep groove (including a groove having the deepest portion) at an end region other than such a center region. Particularly, in one or each end region in the longitudinal direction of the ceramic sintered body, the outermost groove preferably has the shallowest portion.

In the present invention, a plurality of grooves having a width of from 0.1 to 1.5 mm, a length of at least 1 mm and a depth of from 0.03 to 1.0 mm are provided, and it is particularly preferred that the significant difference in the depth of the groove is at least 10%, and {(depth of the deepest portion of the groove) - (depth of the shallowest portion of the groove)} is at least 0.005 mm.

Processing of the groove on the ceramic sintered body of the present invention may be carried out, for example, by mechanical processing, sandblasting or water jet.

The boat of the present invention has suppressed wettability to a molten metal in a direction in parallel with a current direction, by formation of the groove. Thus, arrival of a molten metal to electrodes can be remarkably reduced as compared with a conventional boat having no groove, whereby the metal can be evaporated stably with high efficiency.

On a conventional boat, a cavity is formed so as to prevent the molten metal such as aluminum being dripping from the side surface. However, in the present invention, a cavity is one having grooves with different size or function provided thereon. Therefore, the cavity is not necessarily required in the present invention. However, with respect to one having a cavity, the groove or a pattern by the groove is formed preferably on at least the bottom surface of the cavity. Perspective views illustrating one example of the boat of the present invention are shown in Figs. 1, 3 to 5, and 7 to 10.

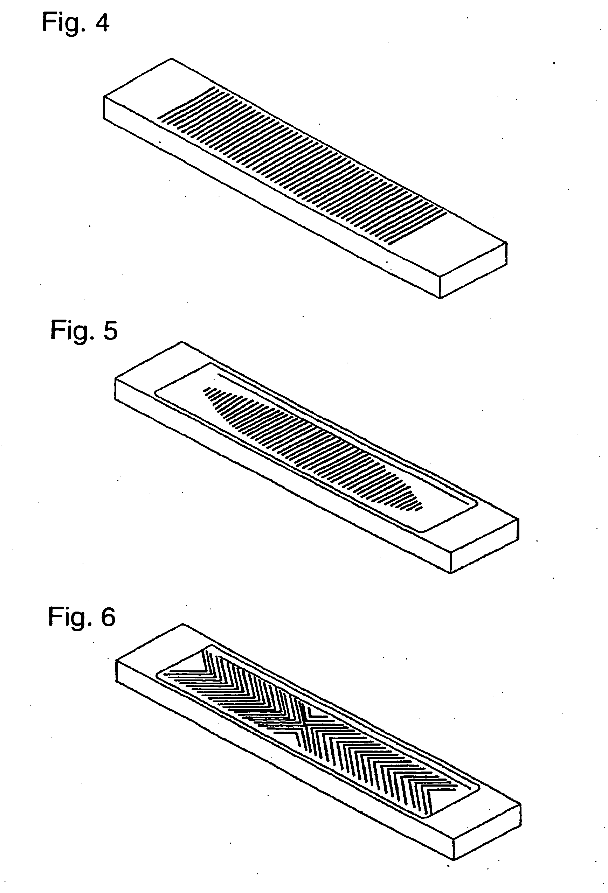

Boats in Figs. 1, 2, 3 and 4 are produced in Examples 1, 3, 4 and 5, respectively. In each of the boats, a pattern is drawn by groove(s), and the area ratios occupied by the pattern are 64% and 76% to the bottom surface area of the cavity in Figs. 1 and 2, respectively, and they are 39% and 55% to the upper surface area of the ceramic sintered body in Figs. 3 and 4, respectively.

In the boat shown in Fig. 5, on the bottom surface of the cavity, 50 grooves having a maximum length of 24 mm, a width of 1 mm and a depth of 0.15 mm are formed with different lengths with a distance of 1 mm at an angle of 90° to a current direction in an elliptic pattern by mechanical processing. The area ratio occupied by the pattern is 50% to the bottom surface area of the cavity.

In the boat shown in Fig. 6, on the bottom surface of the cavity, 44 grooves having a width of 1 mm and a depth of 0.15 mm are formed with a distance of 1 mm at an angle of 45° or 135°C to a current direction in the dogleg pattern by mechanical processing. The area ratio occupied by the pattern is 66% to the bottom surface area of the cavity.

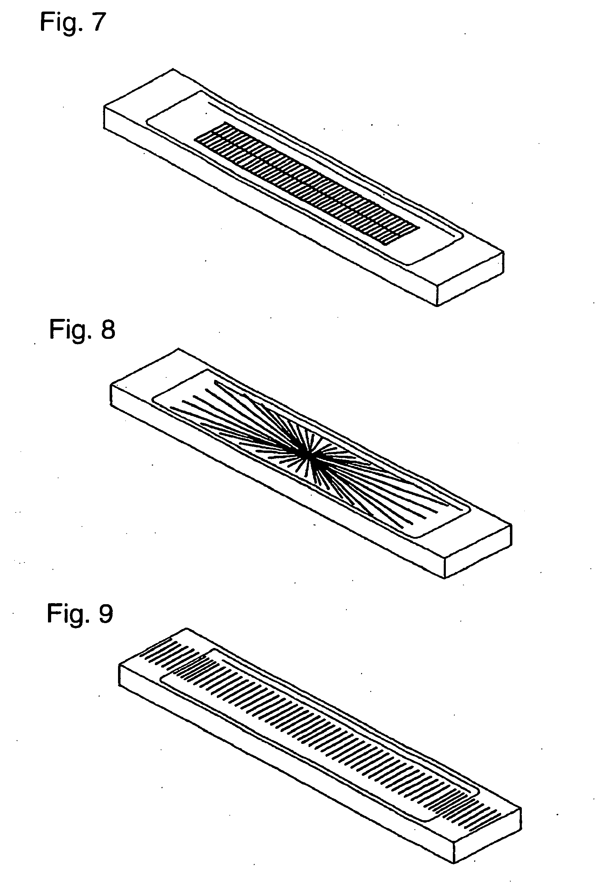

In the boat shown in Fig. 7, on the bottom surface of the cavity, 50 grooves having a width of 1 mm and a depth of 0.15 mm are formed with a distance of 1 mm at an angle of 90° of 180° to a current direction in a lattice pattern by mechanical processing. The area ratio occupied by the pattern is 60% to the bottom surface area of the cavity.

In the boat shown in Fig. 8, on the bottom surface of the cavity, 20 grooves having a width of 1 mm and a depth of 0.15 mm are formed in a radial pattern from the boat center portion toward the boat edge by mechanical processing. The area ratio occupied by the pattern is 61% to the bottom surface area of the cavity.

In the boat shown in Fig. 9, on the bottom surface of the cavity and on the upper surface of the boat out of the cavity, 60 grooves having a length of 20 mm, a width of 1 mm and a depth of 0.15 mm are formed with a distance of 1.5 mm at an angle of 90° to a current direction by mechanical processing. The area ratio occupied by the pattern is 77% to the bottom surface area of the cavity and 67% to the upper surface area of the ceramic sintered body.

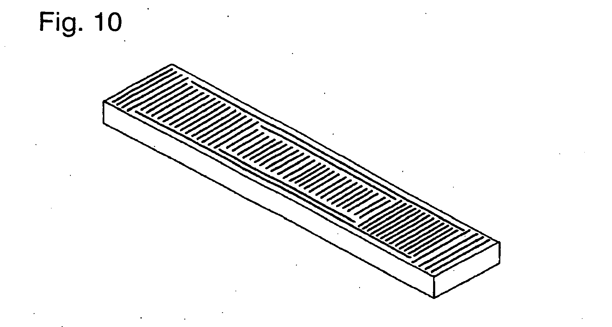

In the boat shown in Fig. 10, on the upper surface of the ceramic sintered body, 60 grooves having a width of 1 mm, a depth of 0.15 mm (and a length of 27 mm at each end portion, 23 mm at an intermediate portion and 19 mm at a center portion) are formed with a distance of 1.5 mm at an angle of 90° to a current direction, and in a direction in parallel with the current direction, one groove having a width of 1 mm, a depth of 0.15 mm and a length of 130 mm is formed at each edge portion, and at the inside thereof, a groove having a width of 1 mm, a depth of 0.15 mm and a length of 65 mm is formed. The area ratio occupied by the patter is 89% to the upper surface area of the ceramic sintered body.

The method for evaporating a metal of the present invention comprises supplying a metal such as an Al wire rod so that it is in contact with part or all of the groove portion on the boat of the present invention (in a case where one groove is formed, it may be in contact with a part of the groove), heating and carrying on heating while the molten metal and the groove are in contact. In such a manner, a metal deposited film is formed on an object substance. As one example of vacuum heating conditions, the degree of vacuum is preferably from $1 \times 10^{-1}$ to $1 \times 10^{-3}$ Pa and the temperature is preferably from 1,400 to 1,600°C.

EXAMPLES

EXAMPLE 1

A material powder mixture comprising 45 mass% of a titanium diboride powder (average particle size: 12 $\mu$m), 30 mass% of a boron nitride powder (average particle size: 0.7 $\mu$m) and 25 mass% of an aluminum nitride powder (average particle size: 10 $\mu$m) was put in a die made of graphite, followed by hot pressing at 1,750°C to produce a ceramic sintered body (relative density: 94.5%, diameter 200 mm $\times$ height 20 mm). From this ceramic sintered body, a rectangular column having a length of 150 mm, a width of 30 mm and a thickness of 10 mm was cut out, and at a center portion on the upper surface thereof, a cavity having a width of 26 mm, a depth of 1 mm and a length of 120 mm was formed by mechanical processing. On the bottom surface of the cavity, 50 grooves having a width of 1 mm, a depth of 0.15 mm and a length of 20 mm were formed with a distance of 1 mm at an angle of 90° to a current direction by mechanical processing to produce a boat. Its perspective schematic view is shown in Fig. 1.

EXAMPLE 2

A boat was produced in the same manner as in Example 1 except that the grooves had a width of 0.5 mm, a depth of 0.1 mm and a length of 20 mm.

EXAMPLE 3 (reference example)

A boat was produced in the same manner as in Example 1 except that on the bottom surface of the cavity of the boat, 35 grooves having a width of 1 mm, a depth of 0.15 mm and a length of 28 mm were formed with a distance of 1 mm at an angle of 45° to a current direction by mechanical processing, and 35 grooves having the same dimensions were formed at an angle of 135° to the current direction, at right angles to the above grooves by mechanical processing. Its perspective schematic view is shown in Fig. 2.

EXAMPLE 4

A boat was produced in the same manner as in Example 1 except that on a center portion of the upper surface of the rectangular column, one linear continuous groove having a width of 1.5 mm, a depth of 0.2 mm and a length of 645 mm was formed at an angle of 90° to a current direction in a stripe pattern directly without forming a cavity. Its perspective schematic view is shown in Fig. 3.

EXAMPLE 5

A boat was produced in the same manner as in Example 1 except that on a center portion of the upper surface of the rectangular column, 50 grooves having a width of 1.0 mm, a depth of 0.15 mm and a length of 25 mm were formed with a distance of 1 mm at an angle of 90° to a current direction by mechanical processing, directly without forming a cavity. Its perspective schematic view is shown in Fig. 4.

EXAMPLE 6

A boat was produced in the same manner as in Example 1 except that the grooves were formed by sandblasting.

EXAMPLE 7

A boat was produced in the same manner as in Example 1 except that the grooves were formed by water jet and that the boat was dried by a vacuum dryer.

COMPARATIVE EXAMPLE 1

A boat was produced in the same manner as in Example 1 except that no groove was formed on the rectangular column.

COMPARATIVE EXAMPLE 2

A boat was produced in the same manner as in Example 1 except that the grooves had a width of 2.0 mm.

COMPARATIVE EXAMPLE 3

A boat was produced in the same manner as in Example 1 except that the grooves had a depth of 2.0 mm.

COMPARATIVE EXAMPLE 4

A boat was produced in the same manner as in Example 1 except that the grooves were formed with a distance of 3.0 mm.

In order to evaluate wettability of the boats in the above Examples and Comparative Examples to a molten metal, each end portion of the boat was connected to an electrode by a clamp, and a voltage to be applied was set so that the temperature at a center portion of the boat would be 1,550°C. Then, a voltage was applied to the boat for heating, an aluminum wire was supplied to the groove portion at a rate of 6.5 g/min for 5 minutes in vacuum at a degree of vacuum of $2 \times 10^{-2}$ Pa and heating was continued. 5 Minutes after initiation of aluminum supply, the upper surface of the boat was photographed, and the wet area was obtained from a comparison between the glowing portion and the molten metal portion. Then, the wet area was divided by the bottom surface area of the cavity with respect to a boat having a cavity or by the upper surface area of the ceramic sintered body with respect to a boat having no cavity to calculate the wet area ratio (%). The results are shown in Table 1.

Further, the boat life was evaluated. Namely, an evaporative test was carried out at a temperature at a boat center portion of 1,500°C in vacuum at a degree of vacuum of $2 \times 10^{-2}$ Pa while an aluminum wire was supplied at a rate of 6.5 g/min for 40 minutes as a unit cycle, and this operation was repeatedly carried out. The number of repetition when the maximum erosion depth on a surface of the boat on which aluminum was evaporated reached 3 mm, was taken as the boat life. The results are shown in Table 1.

TABLE 1

|  | Wet area (%) | Cycles when the erosion depth reached 3 mm |
|---|---|---|
| EXAMPLE 1 | 41 | 12 |
| EXAMPLE 2 | 43 | 11 |
| EXAMPLE 3 | 41 | 12 |

(continued)

|  | Wet area (%) | Cycles when the erosion depth reached 3 mm |
|---|---|---|
| EXAMPLE 4 | 45 | 12 |
| EXAMPLE 5 | 47 | 13 |
| EXAMPLE 6 | 43 | 12 |
| EXAMPLE 7 | 39 | 11 |
| COMPARATIVE EXAMPLE 1 | 24 | 9 |
| COMPARATIVE EXAMPLE 2 | 29 | 8 |
| COMPARATIVE EXAMPLE 3 | 27 | 9 |
| COMPARATIVE EXAMPLE 4 | 26 | 9 |

EXAMPLES 8 to 10

A boat was produced in the same manner as in Example 1 except that instead of the uniform grooves (totally 50 grooves) in Example 1, 50 grooves among which predetermined number of grooves had different depths, as identified in Table 2, were formed from one end to the other end in a longitudinal direction of the boat so that grooves at a center region would be deepest.

EXAMPLES 11 to 13

A boat was produced in the same manner as in Example 8, 9 or 10 except that no cavity was formed on the boat.

EXAMPLE 14

A boat was produced in the same manner as in Example 1 except that each of the 50 grooves had a groove depth of 0.15 mm at a portion of 1/3 from the center in a longitudinal direction of the groove and a groove depth of 0.10 mm at each end portion.
With respect to the boats in Examples 8 to 14, in the same manner as in Examples 1 to 7, the number of repetition when the maximum erosion depth on a surface of the boat on which aluminum was evaporated reached 3 mm, was measured as the boat life. Further, the wettability to a molten metal was measured in accordance with the following method. The results are shown in Table 2.

TEST ON WETTABILITY TO MOLTEN METAL

Each end portion of the boat was connected to an electrode by a clamp, and a voltage to be applied was determined and set so that the temperature at a center portion of the boat would be 1,600°C. Then, a voltage was applied to the boat for heating, an aluminum wire was supplied to the groove portion at a rate of 6.5 g/min for 5 minutes in vacuum at a degree of vacuum of $1 \times 10^{-2}$ Pa, and heating was continued. 5 Minutes after initiation of aluminum supply, the upper surface of the boat was photographed, and with respect to the expansion of a molten metal portion, the width (mm) and the maximum length (mm) at a center portion were measured. The results are shown in Table 2.

TABLE 2

|  | Cavity | Groove construction | | Wet portion with molten metal: maximum length $\times$ width at a center portion (mm) | Boat life (cycles) |
|---|---|---|---|---|---|
|  |  | Number of grooves from one end toward the other end in a longitudinal direction of the boat/groove depth | Significant difference (%) |  |  |
|  |  | 1st to 10th grooves: 0.05 mm |  |  |  |

(continued)

| | Cavity | Groove construction | | Wet portion with molten metal: maximum length × width at a center portion (mm) | Boat life (cycles) |
|---|---|---|---|---|---|
| | | Number of grooves from one end toward the other end in a longitudinal direction of the boat/groove depth | Significant difference (%) | | |
| Example 8 | Present | 11th to 20th grooves: 0.13 mm<br>21th to 30th grooves: 0.20 mm<br>31th to 40th grooves: 0.13 mm<br>41th to 50th grooves: 0.05 mm | 75 | 120 × 26 | 14 |
| Example 9 | Present | 1st to 10th grooves: 0.10 mm<br>11th to 20th grooves: 0.15 mm<br>21th to 30th grooves: 0.20 mm<br>31th to 40th grooves: 0.15 mm<br>41th to 50th grooves: 0.10 mm | 50 | 110 × 26 | 13 |
| Example 10 | Present | 1st to 10th grooves: 0.10 mm<br>11th to 20th grooves: 0.13 mm<br>21th to 30th grooves: 0.15 mm<br>31th to 40th grooves: 0.13 mm<br>41th to 50th grooves: 0.10 mm | 33 | 100 × 26 | 12 |
| Example 11 | Nil | 1st to 10th grooves: 0.05 mm<br>11th to 20th grooves: 0.13 mm<br>21th to 30th grooves: 0.20 mm<br>31th to 40th grooves: 0.13 mm<br>41th to 50th grooves: 0.05 mm | 75 | 120 × 26 | 15 |
| Example 12 | Nil | 1st to 10th grooves: 0.10 mm<br>11th to 20th grooves: 0.15 mm<br>21th to 30th grooves: 0.20 mm | 50 | 110 × 26 | 13 |

(continued)

| | Cavity | Groove construction | | Wet portion with molten metal: maximum length $\times$ width at a center portion (mm) | Boat life (cycles) |
| --- | --- | --- | --- | --- | --- |
| | | Number of grooves from one end toward the other end in a longitudinal direction of the boat/groove depth | Significant difference (%) | | |
| | | 31th to 40th grooves: 0.15 mm 41th to 50th grooves: 0.10 mm | | | |

INDUSTRIAL APPLICABILITY

The boat and the method for evaporating a metal of the present invention are useful for deposition of various metals on e.g. a film.

**Claims**

1. A metal evaporation heating element having one or more grooves in a direction not in parallel with a current direction, on an upper surface of a sintered body, wherein the groove has a width of from 0.1 to 1.5 mm, a depth of from 0.03 to 1 mm and a length of at least 1 mm, **characterized in that**

   (i) the sintered body is a ceramic sintered body comprising titanium diboride ($TiB_2$) and/or zirconium diboride ($ZrB_2$), and boron nitride (BN) and **in that**
   (ii) the direction not in parallel with the current direction makes an angle of from 60 to 120° with the current direction.

2. The metal evaporation heating element according to Claim 1, **characterized by** having at least two grooves with a distance of at most 2 mm.

3. The metal evaporation heating element according to Claim 1 or 2, **characterized in that** the number of grooves is at least 10.

4. The metal evaporation heating element according to Claim 1, **characterized in that** the grooves are crossed so as to form at least one intersection.

5. The metal evaporation heating element according to any one of Claims 1 to 4, **characterized in that** the ceramic sintered body has a cavity, and the groove is formed on the bottom surface of the cavity and/or on the upper surface of the ceramic sintered body.

6. The metal evaporation heating element according to any one of Claims 1 to 5, **characterized in that** a pattern is drawn by a plurality of grooves on the bottom surface of the cavity and/or on the upper surface of the ceramic sintered body.

7. The metal evaporation heating element according to Claim 6, **characterized in that** the area ratio occupied by the pattern is at least 30% to the bottom surface area of the cavity with respect to one having a cavity, or to the upper surface area of the ceramic sintered body with respect to one having no cavity.

8. The metal evaporation heating element according to Claim 7, **characterized in that** the area ratio occupied by the pattern is at least 50%.

9. The metal evaporation heating element according to Claim 7, **characterized in that** the area ratio occupied by the pattern is at least 80%.

10. The metal evaporation heating element according to any one of Claims 1 to 9, **characterized in that** in one groove, or between different grooves, a significant difference is provided in the depth of the groove.

11. The metal evaporation heating element according to Claim 10, **characterized in that** the significant difference in the depth of the groove is at least 10%.

12. The metal evaporation heating element according to Claim 10 or 11, **characterized in that** among a plurality of grooves, the groove having the deepest portion is provided at a center portion in the longitudinal direction of the ceramic sintered body or in the vicinity thereof.

13. The metal evaporation heating element according to any one of Claims 10 to 12, **characterized in that** among the plurality of grooves, the groove having the shallowest portion is provided at one end or each end in the longitudinal direction of the ceramic sintered body.

14. The metal evaporation heating element according to any one of Claims 10 to 13, **characterized in that** {(depth of the deepest portion of the groove) - (depth of the shallowest portion of the groove)} is at least 0.005 mm.

15. A method for evaporating a metal, **characterized by** using the metal evaporation heating element as defined in any one of Claims 1 to 14 and heating a metal in vacuum in a state where the metal is in contact with part or all of the groove.

**Patentansprüche**

1. Heizelement zum Verdampfen von Metall, das auf einer oberen Oberfläche eines gesinterten Körpers eine oder mehrere Rillen in eine Richtung, die nicht parallel zu einer Stromrichtung ist, aufweist, wobei die Rille eine Breite von 0,1 bis 1,5 mm, eine Tiefe von 0,03 bis 1 mm und eine Länge von mindestens 1 mm aufweist, **dadurch gekennzeichnet, dass**

    (i) der gesinterte Körper ein keramischer gesinterter Körper ist, der Titandiborid ($TiB_2$) und/oder Zirkoniumdiborid ($ZrB_2$) und Bornitrid (BN) umfasst und dass
    (ii) die Richtung, die nicht parallel zur Stromrichtung ist, einen Winkel von 60 bis 120° mit der Stromrichtung bildet.

2. Das Heizelement zum Verdampfen von Metall gemäß Anspruch 1, **dadurch gekennzeichnet, dass** es mindestens zwei Rillen in einem Abstand von höchstens 2 mm aufweist.

3. Das Heizelement zum Verdampfen von Metall gemäß Anspruch 1 oder 2, **dadurch gekennzeichnet, dass** die Anzahl der Rillen mindestens 10 beträgt.

4. Das Heizelement zum Verdampfen von Metall gemäß Anspruch 1, **dadurch gekennzeichnet, dass** die Rillen sich kreuzen, sodass sie zumindest einen Kreuzungspunkt bilden.

5. Das Heizelement zum Verdampfen von Metall gemäß einem der Ansprüche 1 bis 4, **dadurch gekennzeichnet, dass** der keramische gesinterte Körper eine Vertiefung aufweist, und dass die Rille auf der unteren Oberfläche der Vertiefung und/oder auf der oberen Oberfläche des keramischen gesinterten Körpers ausgebildet ist.

6. Das Heizelement zum Verdampfen von Metall gemäß einem der Ansprüche 1 bis 5, **dadurch gekennzeichnet, dass** auf der unteren Oberfläche der Vertiefung und/oder auf der oberen Oberfläche des keramischen gesinterten Körpers ein Muster durch eine Vielzahl von Rillen aufgezeichnet ist.

7. Das Heizelement zum Verdampfen von Metall gemäß Anspruch 6, **dadurch gekennzeichnet, dass** das Flächenverhältnis, das von dem Muster belegt ist, mindestens 30% zur unteren Oberfläche der Vertiefung bezüglich eines, das eine Vertiefung aufweist, beträgt oder zur oberen Oberfläche des keramischen gesinterten Körpers bei einem solchen, das keine Vertiefung aufweist.

8. Das Heizelement zum Verdampfen von Metall gemäß Anspruch 7, **dadurch gekennzeichnet, dass** das Flächenverhältnis, das von dem Muster besetzt wird, mindestens 50% beträgt.

**9.** Das Heizelement zum Verdampfen von Metall gemäß Anspruch 7, **dadurch gekennzeichnet, dass** das Flächenverhältnis, das von dem Muster besetzt wird, mindestens 80% beträgt.

**10.** Das Heizelement zum Verdampfen von Metall gemäß einem der Ansprüche 1 bis 9, **dadurch gekennzeichnet, dass** in einer Rille oder zwischen verschiedenen Rillen ein signifikanter Unterschied bezüglich der Tiefe der Rille vorliegt.

**11.** Das Heizelement zum Verdampfen von Metall gemäß Anspruch 10, **dadurch gekennzeichnet, dass** der signifikante Unterschied in der Tiefe der Rille mindestens 10% beträgt.

**12.** Das Heizelement zum Verdampfen von Metall gemäß Anspruch 10 oder 11, **dadurch gekennzeichnet, dass** bei einer Vielzahl von Rillen die Rille mit dem tiefsten Bereich in einem zentralen Bereich in Längsrichtung des keramischen gesinterten Körpers oder in dessen Nähe vorliegt.

**13.** Das Heizelement zum Verdampfen von Metall gemäß einem der Ansprüche 10 bis 12, **dadurch gekennzeichnet, dass** unter der Vielzahl von Rillen die Rille mit dem flachsten Bereich an einem Ende oder an jedem Ende in Längsrichtung des keramischen gesinterten Körpers vorgesehen ist.

**14.** Das Heizelement zum Verdampfen von Metall gemäß einem der Ansprüche 10 bis 13, **dadurch gekennzeichnet, dass** {(Tiefe des tiefsten Bereichs der Rille) - (Tiefe des flachsten Bereichs der Rille)} mindestens 0,005 mm beträgt.

**15.** Verfahren zum Verdampfen von Metall, **dadurch gekennzeichnet, dass** das Heizelement zum Verdampfen von Metall wie in einem der Ansprüche 1 bis 14 definiert verwendet wird und Erhitzen eines Metalls im Vakuum in einem Zustand, in dem das Metall in Kontakt mit einem Teil der oder der gesamten Rille ist.

**Revendications**

**1.** Elément chauffant pour évaporation d'un métal ayant une ou plusieurs rainures dans une direction non parallèle à une direction du courant, sur une surface supérieure d'un corps fritté, dans lequel la rainure a une largeur de 0,1 à 1,5 mm, une profondeur de 0,03 à 1 mm et une longueur d'au moins 1 mm, **caractérisé en ce que**

> (i) le corps fritté est un corps fritté en céramique comprenant du diborure de titane ($TiB_2$) et/ou du diborure de zirconium ($ZrB_2$), et du nitrure de bore (BN) et **en ce que**
> (ii) la direction non parallèle à la direction du courant forme un angle de 60 à 120° avec la direction du courant.

**2.** Elément chauffant pour évaporation d'un métal selon la revendication 1, **caractérisé en ce qu'**il possède au moins deux rainures distantes d'au plus 2 mm l'une de l'autre.

**3.** Elément chauffant pour évaporation d'un métal selon la revendication 1 ou 2, **caractérisé en ce que** le nombre de rainures est d'au moins 10.

**4.** Elément chauffant pour évaporation d'un métal selon la revendication 1, **caractérisé en ce que** les rainures sont croisées de manière à former au moins une intersection.

**5.** Elément chauffant pour évaporation d'un métal selon l'une quelconque des revendications 1 à 4, **caractérisé en ce que** le corps fritté en céramique présente une cavité, et la rainure est formée sur la surface de fond de la cavité et/ou sur la surface supérieure du corps fritté en céramique.

**6.** Elément chauffant pour évaporation d'un métal selon l'une quelconque des revendications 1 à 5, **caractérisé en ce qu'**un motif est dessiné par une pluralité de rainures sur la surface de fond de la cavité et/ou sur la surface supérieure du corps fritté en céramique.

**7.** Elément chauffant pour évaporation d'un métal selon la revendication 6, **caractérisé en ce que** la proportion de l'aire occupée par le motif représente au moins 30 % de l'aire de la surface de fond de la cavité pour un élément possédant une cavité, ou de l'aire de la surface supérieure du corps fritté en céramique pour un élément ne possédant pas de cavité.

**8.** Elément chauffant pour évaporation d'un métal selon la revendication 7, **caractérisé en ce que** la proportion de l'aire occupée par le motif est d'au moins 50 %.

**9.** Elément chauffant pour évaporation d'un métal selon la revendication 7, **caractérisé en ce que** le rapport d'aire occupée par le motif est d'au moins 80 %.

**10.** Elément chauffant pour évaporation d'un métal selon l'une quelconque des revendications 1 à 9, **caractérisé en ce que** dans une rainure, ou entre des rainures différentes, il existe une importante différence de profondeur de la rainure.

**11.** Elément chauffant pour évaporation d'un métal selon la revendication 10, **caractérisé en ce que** l'importante différence de profondeur de la rainure est d'au moins 10 %.

**12.** Elément chauffant pour évaporation d'un métal selon la revendication 10 ou 11, **caractérisé en ce que** parmi une pluralité de rainures, la rainure ayant la partie la plus profonde est agencée au niveau d'une partie centrale dans la direction longitudinale du corps fritté en céramique ou au voisinage de celle-ci.

**13.** Elément chauffant pour évaporation d'un métal selon l'une quelconque des revendications 10 à 12, **caractérisé en ce que** parmi la pluralité de rainures, la rainure ayant la partie la moins profonde est agencée à une extrémité ou à chaque extrémité dans la direction longitudinale du corps fritté en céramique.

**14.** Elément chauffant pour évaporation d'un métal selon l'une quelconque des revendications 10 à 13, **caractérisé en ce que** {(profondeur de la partie la plus profonde de la rainure) - (profondeur de la partie la moins profonde de la rainure)} est d'au moins 0,005 mm.

**15.** Procédé pour évaporer un métal, **caractérisé en ce qu'**il comprend l'utilisation de l'élément chauffant pour évaporation d'un métal tel que défini dans l'une quelconque des revendications 1 à 14, et le chauffage d'un métal sous vide dans un état où le métal est en contact avec une partie ou la totalité de la rainure.

Fig. 1

GROOVE DIRECTION

CURRENT DIRECTION

Fig. 2

Fig. 3

Fig. 4

Fig. 5

Fig. 6

Fig. 7

Fig. 8

Fig. 9

Fig. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 53020256 B
- JP 2000093788 A
- US 2962538 A